# EUROPÄISCHE PATENTSCHRIFT

(11) **EP 4 062 498 B1**
(45) Veröffentlichungstag und Bekanntmachung des Hinweises auf die Patenterteilung: **15.04.2026**
(21) Anmeldenummer: 20797087.2
(22) Anmeldetag: 23.10.2020
(51) Int. Cl.: H01R 12/58, H01R 12/72, H05K 3/3447

(54) **STECKER MIT EINER FÜHRUNGSPLATTE**
PLUG COMPRISING A GUIDE PLATE
FICHE COMPRENANT UNE PLAQUE DE GUIDAGE

(30) Priorität: 20.11.2019 DE 102019217862
(43) Veröffentlichungstag der Anmeldung: 28.09.2022
(73) Patentinhaber: Robert Bosch GmbH, 70442 Stuttgart (DE)
(72) Erfinder: HUMMEL, Daniel, 72762 Reutlingen (DE); KAHLHAMMER, Hannes, 71638 Ludwigsburg (DE); RAMIREZ VILLALOBOS, Hugo Alberto, 32574 Chihuahua (MX); GONDICS, Marton, 2700 Cegled (HU)
(86) Internationale Anmeldenummer: PCT/EP2020/079868
(87) Internationale Veröffentlichungsnummer: WO 2021/099059

(56) Entgegenhaltungen:
- EP-A2- 1 950 841
- GB-A- 2 219 148
- JP-A- 2019 033 012
- US-A1- 2005 085 109

## Beschreibung

### Stand der Technik

Die Erfindung betrifft einen Stecker, insbesondere einen elektrischen Stecker, mit einer elektrisch isolierend ausgebildeten Führungsplatte. Der Stecker weist eine Mehrzahl von insbesondere gestanzten elektrischen Kontaktdrähten, insbesondere Kontakt-Pins auf. Der Kontaktdraht weist einen eckigen, insbesondere viereckigen, Querschnitt auf und ist durch einen Durchbruch in der Führungsplatte geführt und ragt aus der Führungsplatte heraus.

Aus der US 700 47 66 B2 ist eine Führungsplatte für Kontaktdrähte eines Steckers bekannt, wobei die Führungsplatte Durchbrüche zum Durchführen von Kontaktdrähten aufweist, wobei die Durchbrüche einen oval oder rautenförmig ausgebildeten Einführtrichter und einen entsprechend geformten Durchbruch aufweisen.

Bei Steckern mit gestanzten Kontaktdrähten, welche zum Verlöten mit einem Durchbruch in einer Leiterplatte ausgebildet sind, können Grate, welche beim Stanzen an dem Kontaktdraht erzeugt worden sind, beim Einführen in die Leiterplatte, oder beim Durchführen durch eine Führungsplatte abbrechen oder ablösen, und in einem elektrischen Gerät als Flitter Kurzschlüsse verursachen.

Aus der GB 221 91 48 A ist ein Stecker mit einer gestuften, Löcher aufweisenden Halteplatte bekannt, wobei die Stufen jeweils Anschlagflächen ausbilden die ein Verrutschen der Halteplatte verhindern.

Aus der EP 1 950 841 A2 ist ein Steckergehäuse mit Durchgangslöchern zur Durchführung von Kontaktelementen bekannt, bei dem eine schräg gebildete Durchgangslöcherwand ein Berühren einer flachen Seite des Kontaktelements verhindert.

Aus der US 2005/085 109 A1 ist ein Stecker mit einer Führungsplatte mit Durchgangslöchern für Kontaktelemente bekannt, wobei die Führungsplatte eine elastische Verformung eines Steckergehäuses des Steckers verhindern kann.

Die Offenlegungsschrift JP2019033012 A zeigt eine Ausführung eines Kontaktstiftes durch eine Aussparung in einer Führungsplatte. Der Kontaktstift weist dabei eine Gratseite auf mit abstehenden Graten in den Ecken. Korrespondierend zu den Ecken des Kontaktstiftes weist die Aussparung Freisparungen auf, um die abstehenden Grate gegenüber der Aussparung zu beabstanden.

### Offenbarung der Erfindung

Erfindungsgemäß weist jeder Durchbruch entlang einer Dickenerstreckung der Führungsplatte einen Führungsschaft auf. Jeder Führungsschaft weist wenigstens eine eben ausgebildete Wand zum Führen einer flachen Seite des Kontaktdrahts auf. Jeder Führungsschaft weist auch zu der eben ausgebildeten Wand gegenüberliegend wenigstens einen, dazu schräg verlaufenden Wandbereich auf, welcher ausgebildet ist, eine Ecke des Kontaktdrahts zu berühren. Jeder Führungsschaft weist der eben ausgebildeten Wand gegenüberliegend einen im Querschnitt dazu schräg verlaufenden, nämlich bogenförmig oder V förmig oder dachförmig ausgebildeten Wandbereich auf, welcher ausgebildet ist, die Ecke der Gratseite des korrespondierenden Kontaktdrahts zu berühren. Jeder Führungsschaft ist derart ausgebildet, beim Durchführen des korrespondierenden Kontaktdrahts die Ecke der Gratseite gegen den schräg verlaufenden Wandbereich zu pressen, und die Grate dabei zueinander abzuwinkeln. Vorteilhaft kann durch die Flache Seite des Führungsschaftes eine gute Flachführung des Kontaktdrahtes sichergestellt werden. Durch den dazu gegenüberliegenden schräg verlaufenden Wandbereich kann in Verbindung mit der Führung durch den ebenen Wandbereich eine hohe Positioniergenauigkeit des Kontaktdrahtes innerhalb der Führungsplatte und somit auch unter den zueinander benachbarten Kontaktdrähten untereinander bewirkt. Bevorzugt ist der Kontaktdraht als Blechstanzteil ausgebildet, welches beispielsweise zusätzlich durch einen Umformvorgang gebogen und/oder geprägt ist. Hierbei wird von einer Auflageseite eines zur Herstellung von Kontaktdrähten bereitgestellten Rohbleches ein Stanzschneidwerkzeug aufliegend aufgesetzt, welches in Zusammenwirken mit einem Gegenschneidwerkzeug, beispielsweise einer Matrize, ein oder mehrere Kontaktdrähte aus dem Rohblech konturdefiniert abschert bzw. abschneidet. Fertigungsbedingt weist dann eine der Auflageseite des Stanzschneidwerkzeugs gegenüberliegende Gratseite an einer jeweiligen Scherkante entsprechende Grate auf, welche von der jeweiligen Scherkante abstehen. Ein Abscheren der Grate bei der Montage der Kontaktdrähte durch den Durchbruch kann durch dessen definierte Formgebung wirkungsvoll vermieden werden. Hierzu ist die Gratseite eines Kontaktdrahtes zum schräg verlaufenden Wandbereich zugewandt. Demzufolge ist die Auflageseite eines Kontaktdrahtes zu der eben ausgebildeten Wand zugewandt. Insbesondere ist dabei ermöglicht, dass beim Durchführen des Kontaktdrahtes durch den Durchbruch die Anlageseite an der eben ausgebildeten Wand anliegt und der Kontaktdraht mit geringer mechanischen Belastung auf dessen Anlagenseite durch den Durchbruch geführt wird. Es hat sich weiter gezeigt, dass die beim Durchführen mit der Wandung des Durchbruchs in berührenden Kontakt kommenden Grate auf der Gratseite eines Kontaktdrahtes vorteilhaft nicht abgeschert bzw. abgetrennt werden, sondern vielmehr durch schräg auf diese einwirkende Berührkräfte lediglich abknickend verbogen werden. Vorteilhaft kann der Grat so an den Kontaktdraht angeformt bleiben, so dass keine abgelösten Gratpartikel als Flitter entstehen. Zusätzlich nimmt der verbogene Grat eine günstigere Lageposition ein, durch welche dieser auch bei einem nachträglichen Durchführen des Kontaktdrahtes durch einen Durchbruch in einer Leiterplatte - beispielsweise um dort dann einen Lotkontakt auszubilden - nicht so leicht abbrechen. Der Grat kann so durch das Abgewinkeltwerden an den Kontaktdraht, insbesondere an eine flache Seite des Kontaktdrahts, angefaltet werden, womit wiederrum eine Gefahr von Flitterbildung sehr einfach und wirkungsvoll vermieden werden kann. Zusätzlich kann nach einer nachträglichen Durchführung des Kontaktdrahtes durch einen Durchbruch in einer Leiterplatte und einem dort ausgebildeten Lotkontakt der Kontaktdraht mit seiner Anlagenseite auf der eben ausgebildeten Wand im Durchbruch stützend aufliegen. Dies kann beispielsweise auch durch eine entsprechende Anordnung des Kontaktdrahtes zur Leiterplatte hin erzwungen werden, bei welcher bedingt durch die Anordnung eine Vorspannkraft im Kontaktdraht wirksam ist, beispielsweise infolge eines Verspannens des Kontaktdrahtes, so dass die Vorspannkraft die Anlagenseite in Richtung der eben ausgebildeten Wand im Durchbruch zubewegt, bevorzugt bis zum Anlagenkontakt. Durch die ebenflächige Auflage wird die Gefahr einer ansonsten zeitlich wirksam werdenden Whiskerbildung bei hoher Punktbelastung deutlich reduziert, da zeitgleich auch die Gratseite dann maximal zum schräg verlaufenden Wandbereich beabstandet bleibt.

Jeder Kontaktdraht ist bevorzugt ein Kupferdraht, insbesondere aus Kupfer oder einer Kupferlegierung gebildet. Zusätzlich kann dieser - auch nur bereichsweise - verzinnt sein oder eine lotfähige und/oder lotbenetzende Beschichtung aufweisen. Vorteilhaft kann der Kontaktdraht so aufwandsgünstig bereitgestellt werden.

Bevorzugt verläuft jeder Durchbruch quer zu einer Plattenebene. Vorteilhaft kann die Führungsplatte so auf die Kontaktdrähte, insbesondere Kontakt-Pins aufgeschoben werden.

In einer erfindungsgemäß ersten Ausführungsform ist der Wandbereich am Querschnitt bogenförmig, insbesondere kreisbogenförmig, ausgebildet. Vorteilhaft kann so eine halbzylinderförmige Durchbruchwand gebildet sein. Vorteilhaft kann mit der bogenförmig oder kreisbogenförmig ausgebildeten Durchbruchwand der Grat beim Anpressen gegen die bogenförmige Durchbruchwand gleichmäßig abgewinkelt werden.

In einer weiteren erfindungsgemäßen Ausführungsform ist der Wandbereich V-förmig oder dachförmig ausgebildet. Vorteilhaft kann der Grat an der so gebildeten, dachförmigen Schräge in eine der Schräge entsprechende Winkelstellung abgewinkelt werden.

In einer bevorzugten Ausführungsform beträgt ein Winkel der V-Form zwischen 60 und 160 Grad. Weiter bevorzugt beträgt der Winkel der V-Form wenigstens 90 Grad. Vorteilhaft kann der Grat so in einem hohen Maße abgewinkelt werden, bei einer relativ kleinen Durchbruchabmessung.

Jeder Durchbruch weist bevorzugt einen Einführtrichter auf, an welchen sich der Führungsschaft anschließt. Der Einführtrichter erleichtert das Einführen bzw. das Einfädeln eines Kontaktdrahtes durch einen jeweiligen Durchbruch. Dabei kann auch eine nicht achszentrierte Ausrichtung des Kontaktdrahtes zum Durchbruch sicher kompensiert werden. In einer bevorzugten Ausführungsform ist der Einführtrichter wenigstens teilweise oder vollständig kreiskegelförmig ausgebildet. Vorteilhaft kann der Einführtrichter so eine zu allen Seiten gleichmäßig ausgebildete Positionsverschiebung des Kontaktdrahtes einfangen. In einer bevorzugten Ausführungsform ist der Einführtrichter wenigstens teilweise oder vollständig pyramidenförmig ausgebildet. Vorteilhaft kann der Einführtrichter so den Kontaktdraht entlang einer eine Führungsrinne bildenden Pyramidenecke zu dem Führungsschaft hinführen.

In einer bevorzugten Ausführungsform weist der Einführtrichter im Bereich der ebenen Wandseite eine ebene Schräge auf, wobei der Einführtrichter auf der dazu gegenüberliegenden Seite durch einen Kegelabschnitt, insbesondere Stumpfkegelabschnitt, gebildet ist. Vorteilhaft kann der Kontaktdraht so entlang der ebenen Schräge, weiter bevorzugt mittels zwei die ebene Schräge begrenzenden, V-förmigen Rinnen in den Führungsschaft hineingeführt werden, und im Bereich des Kegelabschnitts an den runden oder dachförmigen Wandbereich zum Verformen des Grates hingeführt werden.

In einer bevorzugten Ausführungsform weist der Einführtrichter im Bereich der ebenen Wandseite eine ebene Schräge auf, und weist auf der dazu gegenüberliegenden Seite eine oder zwei Führungsrinnen auf. Vorteilhaft kann der Kontaktdraht so mit einer Ecke des Kontaktdrahtes in einer Pyramidenecke, insbesondere V-förmigen Rinne der Pyramidenecke, zu dem Führungsschaft hingleiten.

In einer bevorzugten Ausführungsform weist der Stecker ein Steckergehäuse auf. Die Führungsplatte weist eine Ausnehmung zum Steckverbinden mit dem Steckergehäuse auf. Vorteilhaft kann die Führungsplatte so auf die Kontaktdrähte aufgesteckt werden, und mit dem Steckergehäuse steckverbunden, insbesondere rastverbunden werden.

In einer bevorzugten Ausführungsform beträgt - bevorzugt im Querschnitt des Durchbruchs - eine Längsabmessung jedes Durchbruchs, insbesondere des Führungsschaftes, gleich einer Querabmessung des Durchbruchs. Vorteilhaft kann der Einführtrichter, und weiter bevorzugt der Führungsschaft, mit kleinen äußeren Abmaßen bereitgestellt sein.

Bevorzugt ist die Führungsplatte oder zusätzlich das Steckergehäuse aus Kunststoff gebildet. Der Kunststoff ist bevorzugt ein Thermoplast, beispielsweise, Polyamid, PMMA (PMMA = Poly-Methyl-Meth-Acrylat), Polycarbonat, POM (POM = Poly-Oxy-Methacrylat), oder ABS (ABS = Acrylnitril-Butadien-Styrol), PBT (PBT = Poly-Butadien-Therephtalat), oder ASA-Coplymer (ASA = Acrylnitril-Styrol-Acrylester).

Die Erfindung wird nun im Folgenden anhand von Figuren und weiteren Ausführungsbeispielen erläutert. Weitere vorteilhafte Ausführungsvarianten ergeben sich aus einer Kombination der in den Figuren und in den abhängigen Ansprüchen beschriebenen Merkmale.
Figur 1 zeigt - schematisch - ein Ausführungsbeispiel für ein Kontaktsystem, umfassend eine Führungsplatte für einen Stecker und einen Kontaktdraht, wobei die Führungsplatte einen Durchbruch mit einem runden Wandbereich aufweist, welcher ausgebildet ist, einen Grat an dem Kontaktdraht umzuformen;
Figur 2 zeigt - schematisch - ein Ausführungsbeispiel für ein Kontaktsystem, umfassend eine Führungsplatte für einen Stecker und einen Kontaktdraht, wobei die Führungsplatte einen Durchbruch mit einem dachförmigen Wandbereich aufweist, welcher ausgebildet ist, einen Grat an dem Kontaktdraht umzuformen;
Figur 3 zeigt - schematisch - ein Ausführungsbeispiel für einen Durchbruch an einer Führungsplatte, welcher ausgebildet ist, einen Grat an einem Kontaktdraht umzuformen, wobei der Durchbruch einen Einführtrichter mit einer Trichterwand mit ebenen und gewölbten Bereichen entlang des Trichterumfangs aufweist;
Figur 4 zeigt - schematisch - ein Ausführungsbeispiel für einen Durchbruch an einer Führungsplatte, welcher ausgebildet ist einen Grat an einem Kontaktdraht umzuformen, wobei der Durchbruch einen Einführtrichter mit einer Trichterwand mit Führungsrinnen entlang des Trichterumfangs aufweist;
Figur 5 zeigt - schematisch - ein Ausführungsbeispiel für einen Durchbruch an einer Führungsplatte in einer Schnittdarstellung, welcher ausgebildet ist, einen Grat an einem Kontaktdraht umzuformen, wobei ein Einführtrichter gestuft ausgebildet ist;
Figur 6 zeigt - schematisch - ein Ausführungsbeispiel für einen Stecker mit einer Führungsplatte, durch die Kontaktdrähte des Steckers hindurchgeführt sind.

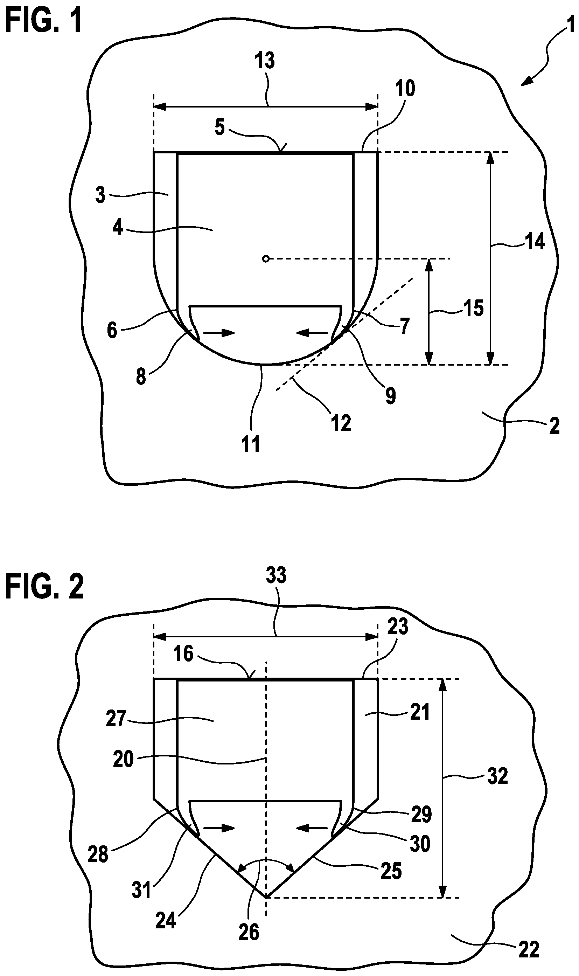

Figur 1 zeigt ein Ausführungsbeispiel für ein Kontaktsystem 1. Das Kontaktsystem 1 weist eine Führungsplatte 2 auf. Die Führungsplatte 2 weist wenigstens einen Durchbruch 3 auf. Der Durchbruch 3 ist zum Durchführen eines Kontaktdrahts 4 ausgebildet, und bildet einen Führungsschaft für den Kontaktdraht 4. Der Kontaktdraht 4 weist in diesem Ausführungsbeispiel einen viereckigen Querschnitt auf. Der Kontaktdraht 4 weist eine flach ausgebildete Seite 5 auf. Die flach ausgebildete Seite 5 entspricht insbesondere einer Anlageseite für ein Stanzschneidwerkzeug bei der Herstellung des Kontaktdrahtes 4. Der Kontaktdraht 4 weist an der Seite 5 gegenüberliegend zwei Ecken 6 und 7 auf. An der Ecke 6 ist ein Grat 8, und an der Ecke 7 ein Grat 9 ausgebildet. Die Grate 8 und 9 sind in diesem Ausführungsbeispiel beim Stanzen des Kontaktdrahts 4 mittels eines Stanzwerkzeugs aus einem Blech erzeugt, wobei ein Stanzwerkzeug den Draht 4, die Seite 5 umschließend, von der Seite 5 herkommend bis hin zu den Ecken 6 und 7 ausgestanzt hat. Dabei sind an den Ecken die Grate 8 und 9 erzeugt worden. Die der flachen Seite 5 gegenüberliegende Seite entspricht demnach einer Gratseite des Kontaktdrahtes 4, welche fertigungsbedingt entsteht.

Der Durchbruch 3 weist eine eben ausgebildete Durchbruchwand 10 auf, welche eine Laibung des Durchbruchs 3 bildet. Zu der ebenen Wand 10 gegenüberliegend weist der Durchbruch 3, und so auch die Führungsplatte 2, eine konkav ausgebildete Durchbruchwand 11 auf. Die Wand 10 und die konkave Wand 11 bilden jeweils einen Umfangsabschnitt entlang der Laibung des Durchbruchs 3.

Der Durchbruch 3 weist eine Längsabmessung 13 auf und eine dazu quer verlaufende Querabmessung 14 auf. Die Längsabmessung 13 entspricht in diesem Ausführungsbeispiel der Querabmessung 14. Eine Krümmung der konkav ausgebildeten Durchbruchwand 11, welche der eben ausgebildeten Durchbruchwand 10 gegenüberliegt, weist in diesem Ausführungsbeispiel einen Krümmungsradius 15 auf. Der Krümmungsradius 15 beträgt in diesem Ausführungsbeispiel die Hälfte der Querabmessung 14, und so auch die Hälfte der Längsabmessung 13.

Der Kontaktdraht 4 kann beim Eingefügtwerden in den Durchbruch 3 mit seiner flachen Seite 5, welche zu den Graten 8 und 9 gegenüberliegend angeordnet ist, an der ebenen Wand 10 anliegen, und dort anliegend in den Durchbruch 3 hineingleiten. Die Grate 8 und 9 werden dabei an der rund ausgebildeten Durchbruchwand 11, insbesondere an der durch die Rundung gebildeten Schräge 12, zueinander abgewinkelt. Die Grate 8 und 9 können so - insbesondere beim weiteren Eingeführtwerden des Kontaktdrahts 4 in einen Durchbruch einer Leiterplatte - nicht mehr an einem Durchbruchrand der Leiterplatte anstoßen, und dort nachteiliger Weise abgebrochen werden.

Figur 2 zeigt ein Ausführungsbeispiel für eine Führungsplatte 22, welche einen Durchbruch 21 aufweist. Der Durchbruch 21 ist zum Durchführen eines Kontaktdrahts 27 ausgebildet, und bildet einen Führungsschaft für den Kontaktdraht 27. Der Durchbruch 21 weist eine eben ausgebildete Durchbruchwand 23 auf, welche entlang eines Laibungsumfangs des Durchbruchs 21 als Umfangsabschnitt ausgebildet ist. Zu der eben ausgebildeten Durchbruchwand 23 gegenüberliegend weist der Durchbruch 21 eine im Querschnitt V-förmige oder dachförmige Durchbruchwand auf. Die V-förmige Durchbruchwand umfasst dabei eine zur eben ausgebildeten Durchbruchwand 23 schräg angeordnete Durchbruchwand 24, und eine sich zu der Durchbruchwand 24 in einem vorbestimmten Winkel 26 erstreckende Durchbruchwand 25 auf. Die Durchbruchwände 24 und 25 bilden jeweils im Querschnitt des Durchbruchs 21 einen Schenkel der V-Form. Eine sich von dem Schnittpunkt der Schenkel 24 und 25 zur gegenüberliegenden ebenen Wand 23 erstreckende Lotgerade 20 erstreckt sich orthogonal zur ebenen Wand 23, und bildet in diesem Ausführungsbeispiel eine Winkelhalbierende des Winkels 26, welcher sich zwischen den zur ebenen Wand 23 jeweils schräg angeordneten Durchbruchwänden 24 und 25 erstreckt.

In den Durchbruch 21 ist in diesem Ausführungsbeispiel ein Kontaktdraht 27 eingeführt. Der Kontaktdraht 27 weist eine flache Seite 16 auf, welche sich in diesem Ausführungsbeispiel beim Einführen in den Durchbruch 21 an die ebene Wand 23 anschmiegt. Die flache Seite 16 entspricht insbesondere einer Anlageseite für ein Stanzschneidwerkzeug bei der Herstellung des Kontaktdrahtes 27. Zu der flachen Seite 16 gegenüberliegend - insbesondere einer Gratseite des Kontaktdrahtes - weist der Kontaktdraht 27 zwei Ecken 28 und 29 auf. An der Ecke 28 ist ein Grat 31 und an der Ecke 29 ein Grat 30 ausgebildet. Beim Einführen in den Durchbruch 21 werden die Grate an der durch die V-förmigen Durchbruchwand, gebildet aus den Wandteilen 24 und 25, abgewinkelt, und so aufeinander zu gebogen.

In diesem Ausführungsbeispiel entspricht eine Querabmessung 32 des Durchbruchs 21 einer Längsabmessung 33 des Durchbruchs 21. In einer anderen Ausführungsform kann der Durchbruch 21 eine größte Längsabmessung aufweisen, die ungleich, insbesondere größer oder kleiner ist als die größte Breitenabmessung des Durchbruchs.

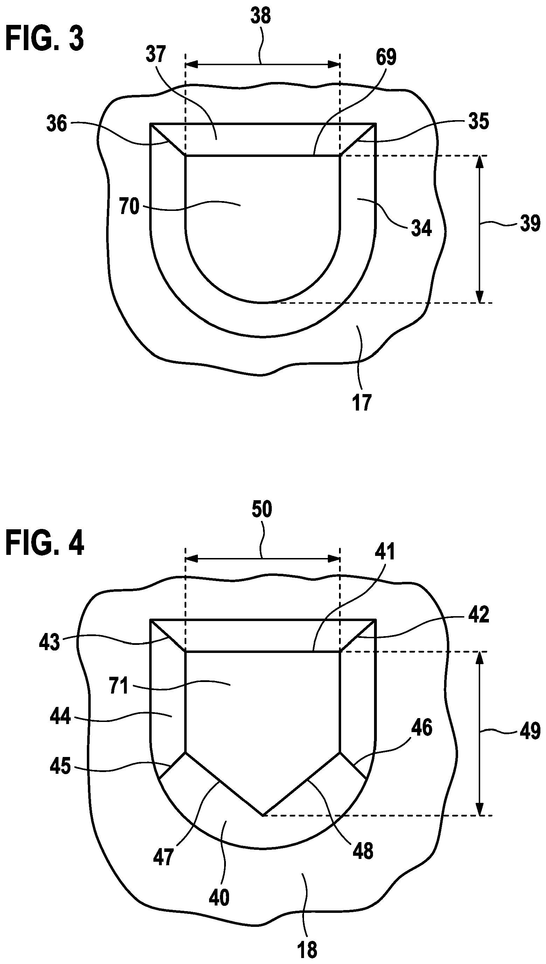

Figur 3 zeigt ein Ausführungsbeispiel für eine Führungsplatte 17. Die Führungsplatte 17 weist einen Durchbruch 70 zum Aufnehmen eines Kontaktdrahtes auf. Der Durchbruch 70 bildet in diesem Ausführungsbeispiel einen Führungsschaft für einen Kontaktdraht. Der Durchbruch 70 weist in diesem Ausführungsbeispiel einen Einführtrichter 34 auf. Der Durchbruch 70 weist auch eine eben ausgebildete Durchbruchwand 69 auf. Der Einführtrichter 34 weist im Bereich der eben ausgebildeten Wand 69 eine eben ausgebildete Schräge 37 auf, welche sich in einem vorbestimmten Winkel zur ebenen Wand 69 erstreckt. Ein Kontaktdraht kann so mit einer an einer Stirnseite ausgebildeten Kante an der ebenen Schräge 37 in den Durchbruch 70 hineingleiten. Die ebene Schräge 37 wird durch zwei Rinnen 35 und 36, insbesondere Führungsrinnen begrenzt.

Die Rinnen 35 und 36 bilden eine Begrenzung der schrägen Trichterwand 37 zu einem übrigen Trichterbereich entlang des Trichterumlaufs. Die Schräge 37 bildet in diesem Ausführungsbeispiel gemeinsam mit den Rinnen 35 und 36, und der an die Rinnen 35 und 36 jeweils anschließenden Trichterwand, einen Teil oder die Hälfte einer Stumpfkegelpyramide. Der Einführtrichter 34 ist zu der schräg ausgebildeten Trichterwand 37, welche zur ebenen Durchbruchwand 69 schräg in einem vorbestimmten Winkel verläuft, halbkegelstumpfförmig, insbesondere halbkreiskegelstumpfförmig, ausgebildet. An der so ausgebildeten Trichterwand können zwei Ecken eines Kontaktdrahtes beim Einführen in den Durchbruch 70 in den Durchbruch 70 hineingleiten.

Der Durchbruch 70 weist in diesem Ausführungsbeispiel eine Längsabmessung 38 auf, welche gleich groß ausgebildet ist wie eine dazu quer verlaufende Querabmessung 39.

In einer anderen Ausführungsform kann der Durchbruch 70 eine größte Längsabmessung aufweisen, die ungleich, insbesondere größer oder kleiner ist als die größte Breitenabmessung des Durchbruchs.

Der in Figur 3 dargestellte Einführtrichter 34 kann an der in Figur 1 dargestellten Führungsplatte 2 an dem Durchbruch 3 ausgebildet sein. Der Durchbruch 3 tritt dabei an die Stelle des Durchbruchs 70 in Figur 3.

Figur 4 zeigt ein Ausführungsbeispiel für einen Einführtrichter 44. Der Einführtrichter 44 umschließt einen Durchbruch 71, und ist ausgebildet, einen Kontaktdraht zum Durchführen durch den Durchbruch 71 einzufangen.

Der Durchbruch 71, der in diesem Ausführungsbeispiel einen Führungsschaft für den Kontaktdraht bildet, und der diesen umschließende Einführtrichter 44 ist in einer Führungsplatte 18 ausgebildet. Der Durchbruch 71 weist eine eben ausgebildete Durchbruchwand 41 auf, zu der gegenüberliegend im Querschnitt zwei jeweils einen V-Schenkel bildende Durchbruchwände 47 und 48 angeordnet sind. Der Einführtrichter 44 weist in diesem Ausführungsbeispiel vier Rinnen 42, 43, 45 und 46, insbesondere Führungsrinnen auf, welche jeweils in ein Durchbrucheck des Durchbruchs 71 hineinlaufen. Vorteilhaft kann so eine Ecke eines Führungsdrahtes in einer der Rinnen entlang einer Längserstreckung der Rinne in den Durchbruch 71 hineingeführt werden. Der Einführtrichter 44 weist zu der ebenen Durchbruchwand 41 gegenüberliegend einen rund ausgebildeten Randbereich 40 auf. Der Trichterwandbereich 40 ist in diesem Ausführungsbeispiel als Stumpfkegelsegment, insbesondere Stumpfkegelkreissegment, ausgebildet.

Eine quer zu einer Längsabmessung des Durchbruchs 41 ausgebildete Querabmessung 49 des Durchbruchs 71 ist in diesem Ausführungsbeispiel genauso lang ausgebildet, wie die Längsabmessung 50. Die Längsabmessung 50 entspricht in diesem Ausführungsbeispiel der Längserstreckung der ebenen Durchbruchwand 41 im Querschnitt des Durchbruchs 71. Die Querabmessung 49 entspricht in diesem Ausführungsbeispiel einer Längsabmessung einer Lotgeraden von einem durch die Schrägen 47 und 48 gebildeten Scheitel bis hin zu der eben ausgebildeten Durchbruchwand 41.

In einer anderen Ausführungsform kann der Durchbruch 71 eine größte Längsabmessung aufweisen, die ungleich, insbesondere größer oder kleiner ist als die größte Breitenabmessung des Durchbruchs.

Der in Figur 4 dargestellte Einführtrichter 44 kann an der in Figur 2 dargestellten Führungsplatte 22 verwirklicht sein. Der in Figur 2 dargestellte Durchbruch 21 tritt dabei an die Stelle des in Figur 4 dargestellten Durchbruchs 71. Der Einführtrichter 44 umgibt so den in Figur 2 dargestellten Durchbruch 21. Die in Figur 4 dargestellte ebene Durchbruchwand 41 tritt dabei an Stelle der in Figur 2 dargestellten ebenen Durchbruchwand 23, und die zur ebenen Durchbruchwand 41 schräg angeordnete und gegenüberliegende Durchbruchwand 47 tritt an Stelle der Durchbruchwand 24, und die schräg angeordnete Durchbruchwand 48 an Stelle der Durchbruchwand 25. Der Kontaktdraht 27 kann so in dem Einführtrichter 44 eingefangen werden, und sicher in den Durchbruch 21 hineingleiten. Die Grate 30 beziehungsweise 31 werden dann in dem durch die schrägen Durchbruchwände 47 und 48 gebildeten Dachbereich des Durchbruchs 71 abgewinkelt.

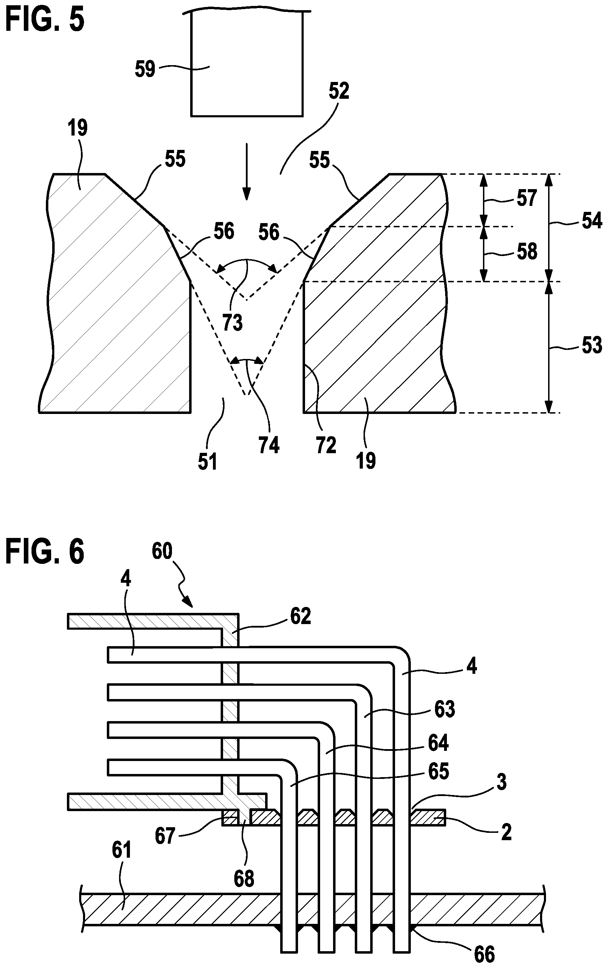

Figur 5 zeigt ein Ausführungsbeispiel für einen Durchbruch 51 mit einem Einführtrichter 52, welcher in einer Führungsplatte 19 ausgebildet ist. Der Durchbruch 51 weist einen Führungsschaft 72 auf. Der Führungsschaft 72 weist beispielsweise im Querschnitt die Form und Abmessung eines der zuvor beschriebenen Durchbrüche gemäß Figur 1 oder Figur 2 auf.

Der in Figur 5 dargestellte Einführtrichter 52 ist in diesem Ausführungsbeispiel mit einem gestuften Einführwinkel ausgebildet. Der Einführtrichter 52 weist einen Trichterwandbereich 55 auf, welcher einen vorbestimmten Trichterwinkel 73 aufweist.

Eine Längserstreckung 53 des Führungsschaftes 72 des Durchbruchs in der Führungsplatte 19 ist in diesem Ausführungsbeispiel größer ausgebildet, als eine Längserstreckung 54 des Einführtrichters 52 entlang der Dickenerstreckung der Führungsplatte 19.

Der Einführtrichter 52 weist einen Trichterwandbereich 56 auf, dessen Trichterwinkel 74 kleiner ausgebildet ist, als der Trichterwinkel 73 des Trichterwandbereichs 55. Der Trichterwandbereich 56 erstreckt sich zwischen dem Trichterwandbereich 55 und dem Führungsschaft 72.

Der Trichterwandbereich 55 bildet somit eine erste Trichterstufe, an die eine zweite Trichterstufe, gebildet durch den Trichterwandbereich 56, anschließt. Die zweite Trichterstufe, gebildet durch die Trichterwand 56, ist ausgebildet, einen Grat, beispielsweise den in Figur 1 dargestellten Grat 8 oder 9, oder den in Figur 2 dargestellten Grat 30 oder 31, beim Einführen eines Kontaktdrahtes 59, an dem ein solcher Grat ausgebildet sein kann, allmählich abzuwinkeln und so an den Kontaktdraht 59 anzufalten. Der Grat 8 oder 9 kann so umgeformt werden.

Eine Längsabmessung 58 der zweiten Trichterstufe entspricht in diesem Ausführungsbeispiel einer Längsabmessung 57 der ersten Trichterstufe, jeweils entlang der Dickenerstreckung der Führungsplatte 19.

Figur 6 zeigt ein Ausführungsbeispiel für einen Stecker 60, welcher in einer Schnittdarstellung dargestellt ist. Der Stecker 60 weist ein Steckergehäuse 62, insbesondere Kunststoffgehäuse, auf. Der Stecker 60 weist auch eine Mehrzahl von Kontaktdrähten, in diesem Ausführungsbeispiel vier Kontaktdrähten, auf. Einer der Kontaktdrähte ist beispielsweise der in Figur 1 bereits dargestellte Kontaktdraht 4. Der Kontaktdraht 4 erstreckt sich mit einem Endabschnitt in eine zum Kontaktieren eines Gegensteckers ausgebildete Steckaufnahme des Steckers 60. Ein dazu gegenüberliegendes Ende des Kontaktdrahtes 4 erstreckt sich abgewinkelt von dem Gehäuse 62 abweisend, und ist zum Verlöten mit einer Leiterplatte 61 ausgebildet.

Der Stecker 60 umfasst in diesem Ausführungsbeispiel noch weitere Kontaktdrähte 63, 64 und 65, welche sich jeweils parallel zu dem Kontaktdraht 4 beabstandet erstrecken. Die Kontaktdrähte 4, 63, 64 und 65 sind jeweils durch einen für den jeweiligen Kontaktdraht in einer Führungsplatte 2 ausgebildeten Durchbruch hindurchgeführt. Die Führungsplatte 2 ist Bestandteil des Steckers 60. Der Stecker 60 weist zum Verbinden mit der Führungsplatte 2 einen Vorsprung 68 auf, welcher ausgebildet ist, in eine Aussparung 67 in der Führungsplatte 2 einzugreifen. Die Führungsplatte 2 kann so auf den Vorsprungsbereich 68 aufgesteckt, und somit mit dem Gehäuse 62 kraftschlüssig und/oder formschlüssig verbunden werden.

Der Kontaktdraht 4 ist dabei durch den Durchbruch 3 in der Führungsplatte 2 geführt. Der Durchbruch 3 kann dabei entsprechend dem in Figur 1 dargestellten Durchbruch 3 in der Führungsplatte 2 ausgebildet sein. Alternativ kann die Ausführung auch angepasst sein an einen Durchbruch, wie in der Fig. 2 offenbart. An dem Kontaktdraht 4 oder an den weiteren Kontaktdrähten 63, 64 oder 65 ausgebildete Grate können so an dem schrägen Wandbereich des Durchbruchs abgewinkelt verformt werden. Die Kontaktdrähte des Steckers 60 können dann in jeweilige Durchbrüche der Leiterplatte 61, insbesondere THT-Leiterplatte (THT = Through-Hole-Technology), hindurchgeführt werden und mittels eines Lotmittels 66 mit der Leiterplatte 61 verlötet werden. Im verlöteten Zustand sind die Kontaktdrähte 4, 63, 64, 65 in einer insbesondere leicht verspannten Anordnung zwischen dem Stecker und der Leiterplatte 61, so dass in diesen eine Vorspannkraft wirksam ist, welche die Kontaktdrähte 4, 63, 64, 65 zur jeweils eben ausgebildeten Wand 5, 16 im durchgeführten Durchbruch 3, 21 zubewegt, insbesondere an diese anliegen lässt. Ein Kontaktdraht 4, 63, 64, 65 ist dabei innerhalb eines durchgeführten Durchbruchs 3, 21 in der Führungsplatte 2, 22 derart orientiert, dass die Anlagenseite 5 des Kontaktdrahtes 4, 63, 64, 65 der eben ausgebildeten Wand 10, 23 zugewandt ist und die Gratseite der konkav ausgebildete Durchbruchwand 11 bzw., der schräg ausgebildeten Durchbruchwand 24, 25 zugewandt ist.

Von dem Stecker 60 können so vorteilhaft keine von einem Kontaktdraht abgehende Grat-Flitter einen Kurzschluss verursachen. Zusätzlich ist eine Whiskerbildung im Betrieb des Steckers 60 deutlich reduziert.

## Patentansprüche

1. Stecker (60), mit einer elektrisch isolierend ausgebildeten Führungsplatte (2, 22, 17, 18, 19), wobei die Führungsplatte (2, 22, 17, 18, 19) eine Mehrzahl von gestanzten elektrischen Kontaktdrähten (4, 27, 59, 63, 64, 65) aufweist, wobei jeder Kontaktdraht (4, 27, 59, 63, 64, 65) einen viereckigen Querschnitt aufweist und durch einen korrespondierenden Durchbruch (3, 21, 51, 70, 71) in der Führungsplatte (2, 22, 17, 18, 19) geführt ist und aus der Führungsplatte (2, 22, 17, 18, 19) herausragt, wobei jeder Kontaktdraht eine flache Seite und gegenüberliegend eine Gratseite aufweist, wobei an Ecken (6.7) der Gratseite Grate (8,9) ausgebildet sind, und wobei jeder korrespondierende Durchbruch (3, 21, 51, 70, 71) entlang einer Dickenerstreckung der Führungsplatte (2, 22, 17, 18, 19) einen Führungsschaft (70, 71, 72) aufweist, wobei jeder Führungsschaft (70, 71, 72) wenigstens eine eben ausgebildete Wand (10, 23, 41) zum Führen der flachen Seite des korrespondierenden Kontaktdrahts (4, 27, 59, 63, 64, 65) aufweist, wobei der Führungsschaft der eben ausgebildeten Wand gegenüberliegend einen im Querschnitt dazu schräg verlaufenden, nämlich bogenförmig oder V förmig oder dachförmig ausgebildeten Wandbereich aufweist, welcher ausgebildet ist, die Ecke der Gratseite des korrespondierenden Kontaktdrahts (4, 27, 59, 63, 64, 65) zu berühren und wobei der Führungsschaft derart ausgebildet ist, beim Durchführen des korerspondierenden Kontaktdrahts (4, 27, 59, 63, 64, 65) die Ecke der Gratseite gegen den schräg verlaufenden Wandbereich zu pressen, und die Grate dabei zueinander abzuwinkeln.

2. Stecker (60) nach Anspruch 1,
**dadurch gekennzeichnet, dass**
der bogenförmige Wandbereich (11, 55, 56) kreisbogenförmig ausgebildet ist.

3. Stecker (60) nach Anspruch 1,
**dadurch gekennzeichnet, dass**
ein Winkel (26) der V-Form zwischen 60 und 160 Grad beträgt.

4. Stecker (60) nach einem der vorhergehenden Ansprüche,
**dadurch gekennzeichnet, dass** jeder Durchbruch (3, 21, 51, 70, 71) einen Einführtrichter (34, 37, 44, 52) aufweist, an welchen sich der korrespondierende Führungsschaft (70, 71, 72) anschließt.

5. Stecker (60) nach Anspruch 4,
**dadurch gekennzeichnet, dass** jeder Einführtrichter (34, 37, 44, 52) wenigstens teilweise kreiskegelförmig ausgebildet ist.

6. Stecker (60) nach einem der Ansprüche 4 bis 5,
**dadurch gekennzeichnet, dass** jeder Einführtrichter (34, 37, 44, 52) wenigstens teilweise pyramidenförmig ausgebildet ist.

7. Stecker (60) nach einem der Ansprüche4 bis 6,
**dadurch gekennzeichnet, dass** jeder Einführtrichter (34, 44, 52) im Bereich der ebenen Wandseite (10, 23, 69, 41) eine ebene Schräge (37) aufweist und auf der dazu gegenüberliegenden Seite durch einen Kegelabschnitt (40) gebildet ist.

8. Stecker (60) nach einem der vorhergehenden Ansprüche 4 bis 7,
**dadurch gekennzeichnet, dass** jeder Einführtrichter (34, 44, 52) im Bereich der ebenen Wandseite (10, 23, 69, 41 eine ebene Schräge (37) aufweist und auf der dazu gegenüberliegenden Seite Führungsrinnen aufweist.

9. Stecker (60) nach einem der vorhergehenden Ansprüche,
**dadurch gekennzeichnet, dass**
der Stecker (60) ein Steckergehäuse (62) aufweist und die Führungsplatte (2, 22, 17, 18, 19) eine Ausnehmung (67) zum Steckverbinden mit dem Steckergehäuse (62) aufweist.

10. Stecker (60) nach einem der vorhergehenden Ansprüche,
**dadurch gekennzeichnet, dass**
eine Längsabmessung (13, 33, 38, 50) jedes Durchbruchs (3, 21, 51, 70, 71) gleich einer Querabmessung (14, 32, 30, 49) des Durchbruchs (3, 21, 51, 70, 71) beträgt.

## Claims

1. Plug (60), with an electrically insulating guide plate (2, 22, 17, 18, 19), wherein the guide plate (2, 22, 17, 18, 19) has a plurality of stamped electrical contact wires (4, 27, 59, 63, 64, 65), wherein each contact wire (4, 27, 59, 63, 64, 65) has a square cross section and is guided through a corresponding aperture (3, 21, 51, 70, 71) in the guide plate (2, 22, 17, 18, 19) and protrudes from the guide plate (2, 22, 17, 18, 19), wherein each contact wire has a flat side and, situated opposite, a burr side, wherein burrs (8, 9) are formed at corners (6.7) of the burr side, and wherein each corresponding aperture (3, 21, 51, 70, 71) has a guide shaft (70, 71, 72) along a thickness extent of the guide plate (2, 22, 17, 18, 19), wherein each guide shaft (70, 71, 72) has at least one planar wall (10, 23, 41) for guiding the flat side of the corresponding contact wire (4, 27, 59, 63, 64, 65), wherein the guide shaft of the planar wall has, situated opposite, a, specifically arcuate or V-shaped or roof-like, wall region which runs obliquely to the planar wall in cross section and is designed to touch the corner of the burr side of the corresponding contact wire (4, 27, 59, 63, 64, 65) and wherein the guide shaft is designed in such a way as to press the corner of the burr side against the obliquely running wall region when the corresponding contact wire (4, 27, 59, 63, 64, 65) is guided through and to angle the burrs in relation to each other in the process.

2. Plug (60) according to Claim 1,
**characterized in that**
the arcuate wall region (11, 55, 56) is designed in the form of a circular arc.

3. Plug (60) according to Claim 1,
**characterized in that**
an angle (26) of the V shape is between 60 and 160 degrees.

4. Plug (60) according to any of the preceding claims,
**characterized in that**
each aperture (3, 21, 51, 70, 71) has an insertion funnel (34, 37, 44, 52) which is adjoined by the corresponding guide shaft (70, 71, 72).

5. Plug (60) according to Claim 4,
**characterized in that**
each insertion funnel (34, 37, 44, 52) is designed at least partially in the form of a circular cone.

6. Plug (60) according to either of Claims 4 and 5,
**characterized in that**
each insertion funnel (34, 37, 44, 52) is designed at least partially in the form of a pyramid.

7. Plug (60) according to any of Claims 4 to 6,
**characterized in that**
each insertion funnel (34, 44, 52) has a planar slope (37) in the region of the planar wall side (10, 23, 69, 41) and is formed by a conical portion (40) on the opposite side.

8. Plug (60) according to any of the preceding Claims 4 to 7, **characterized in that**
each insertion funnel (34, 44, 52) has a planar slope (37) in the region of the planar wall side (10, 23, 69, 41) and has guide channels on the opposite side.

9. Plug (60) according to any of the preceding claims,
**characterized in that**
the plug (60) has a plug housing (62) and the guide plate (2, 22, 17, 18, 19) has a recess (67) for plug-connection to the plug housing (62).

10. Plug (60) according to any of the preceding claims,
**characterized in that**
a longitudinal dimension (13, 33, 38, 50) of each aperture (3, 21, 51, 70, 71) is equal to a transverse dimension (14, 32, 30, 49) of the aperture (3, 21, 51, 70, 71).

## Revendications

1. Fiche (60), comprenant une plaque de guidage réalisée de manière électriquement isolante (2, 22, 17, 18, 19), la plaque de guidage (2, 22, 17, 18, 19) présentant une pluralité de fils de contact électriques estampés (4, 27, 59, 63, 64, 65), chaque fil de contact (4, 27, 59, 63, 64, 65) présentant une section transversale quadrilatérale et étant guidé à travers une percée correspondante (3, 21, 51, 70, 71) dans la plaque de guidage (2, 22, 17, 18, 19) et dépassant de la plaque de guidage (2, 22, 17, 18, 19), chaque fil de contact présentant une face plane et, à l'opposé, une face à bavures, des bavures (8,9) étant formées aux coins (6.7) de la face à bavures, et chaque percée correspondante (3, 21, 51, 70, 71) présentant, le long d'une étendue en épaisseur de la plaque de guidage (2, 22, 17, 18, 19), un manchon de guidage (70, 71, 72), chaque manchon de guidage (70, 71, 72) présentant au moins une paroi (10, 23, 41) réalisée de manière plane pour guider la face plane du fil de contact correspondant (4, 27, 59, 63, 64, 65), le manchon de guidage présentant, à l'opposé de la paroi plane, une zone de paroi s'étendant de manière oblique en section transversale, à savoir en forme d'arc, de V ou de toit, qui est conçue pour toucher le coin de la face à bavures du fil de contact correspondant (4, 27, 59, 63, 64, 65), et le manchon de guidage étant conçu, lors du passage du fil de contact correspondant (4, 27, 59, 63, 64, 65), pour presser le coin de la face à bavures contre la zone de paroi oblique, et pour replier les bavures l'une par rapport à l'autre.

2. Fiche (60) selon la revendication 1,
**caractérisée en ce que**
la zone de paroi en forme d'arc (11, 55, 56) est réalisée en arc de cercle.

3. Fiche (60) selon la revendication 1,
**caractérisée en ce que**
un angle (26) de la forme en V est compris entre 60 et 160 degrés.

4. Fiche (60) selon l'une des revendications précédentes,
**caractérisée en ce que**
chaque percée (3, 21, 51, 70, 71) comporte un entonnoir d'introduction (34, 37, 44, 52) auquel se raccorde le manchon de guidage correspondant (70, 71, 72).

5. Fiche (60) selon la revendication 4,
**caractérisée en ce que**
chaque entonnoir d'introduction (34, 37, 44, 52) est réalisé au moins partiellement en forme de cône circulaire.

6. Fiche (60) selon l'une des revendications 4 à 5,
**caractérisée en ce que**
chaque entonnoir d'introduction (34, 37, 44, 52) est réalisé au moins partiellement en forme de pyramide.

7. Fiche (60) selon l'une des revendications 4 à 6,
**caractérisée en ce que**
chaque entonnoir d'introduction (34, 44, 52) présente une pente plane (37) dans la zone de la face de paroi plane (10, 23, 69, 41) et est formé, sur la face opposée, par une section conique (40).

8. Fiche (60) selon l'une des revendications 4 à 7 précédentes, **caractérisée en ce que**
chaque entonnoir d'introduction (34, 44, 52) présente une pente plane (37) dans la zone de la face de paroi plane (10, 23, 69, 41) et présente des rainures de guidage sur la face opposée.

9. Fiche (60) selon l'une des revendications précédentes,
**caractérisée en ce que**
la fiche (60) comporte un boîtier de fiche (62) et **en ce que** la plaque de guidage (2, 22, 17, 18, 19) présente un évidement (67) pour l'enfichage dans le boîtier de fiche (62).

10. Fiche (60) selon l'une des revendications précédentes,
**caractérisée en ce que**
une dimension longitudinale (13, 33, 38, 50) de chaque percée (3, 21, 51, 70, 71) est égale à une dimension transversale (14, 32, 30, 49) de la percée (3, 21, 51, 70, 71).
